(19)

**Europäisches Patentamt**
**European Patent Office**
**Office européen des brevets**

(11)  **EP 4 521 169 A1**

(12)  **EUROPEAN PATENT APPLICATION**

(43) Date of publication:
**12.03.2025  Bulletin 2025/11**

(21) Application number: **23195956.0**

(22) Date of filing: **07.09.2023**

(51) International Patent Classification (IPC):
**G03F 7/20** (2006.01)

(52) Cooperative Patent Classification (CPC):
**G03F 7/70258; G03F 7/705**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
- **Carl Zeiss SMT GmbH**
  **73447 Oberkochen (DE)**
- **ASML Netherlands B.V.**
  **5504 DR Veldhoven (NL)**

(72) Inventors:
- **FUCHS, Sebastian**
  **73447 Oberkochen (DE)**
- **FISCHBACH, Joachim**
  **73447 Oberkochen (DE)**

- **VON HODENBERG, Martin**
  **73447 Oberkochen (DE)**
- **GRUNER, Toralf**
  **73447 Oberkochen (DE)**
- **MANGER, Matthias**
  **73447 Oberkochen (DE)**
- **SCHOORMANS, Carolus J. C.**
  **5504 DR Veldhoven (NL)**
- **VAN DER WIJST, Marc Wilhelmus Maria**
  **5504 DR Veldhoven (NL)**
- **BUTLER, Hans**
  **5504 DR Veldhoven (NL)**

(74) Representative: **Zeuner Summerer Stütz
Patent- und Rechtsanwälte
Partnerschaft
Nußbaumstraße 8
80336 München (DE)**

(54)  **METHOD OF OPERATING A MICROLITHOGRAPHIC PROJECTION EXPOSURE APPARATUS**

(57)    A method of operating a microlithographic projection exposure apparatus (10) is described. The exposure apparatus comprises a mask holder (20) for holding a mask (18), a substrate holder (26) for holding a substrate (24), a projection lens (30) having several optical elements (R1 - R4) for imaging mask structures of the mask onto the substrate and a manipulator system (34), wherein the optical elements, the mask holder and the substrate holder each are an optical path element in an exposure optical path of the projection exposure apparatus and the manipulator system is configured for adjusting several travels, defined by travel variables (68), at the optical path elements of the projection lens. The method comprises the following steps: providing a wave front deviation (50) of the projection lens, and determining a control command (42) comprising travels for the manipulator system for correcting the wave front deviation using a model (60). The model describes the wave front deviation as a function of the travel variables and for this comprises a group of offset coefficients (62), which are independent of the travel variables, a group of linear coefficients (64), which are each attributed to one of the travel variables to the power of one, and a group of quadratic coefficients (66), which are each attributed to a product of two of the travel variables or to a square of one of the travel variables. The offset coefficients (62) are calibrated more frequently than the linear coefficients (64).

Fig. 2

## Description

Background of the invention

The invention relates to a method of operating a microlithographic projection exposure apparatus.

A microlithographic projection exposure apparatus allows the generation of structures on a substrate in the form of a semiconductor wafer during the production of semiconductor components. To this end, the projection exposure apparatus comprises a projection lens having a plurality of optical elements, for imaging mask structures on the wafer during the exposure process.

A projection lens with wave front aberrations that are as small as possible is required to image the mask structures on the wafer as precisely as possible. Therefore, projection lenses are equipped with a manipulator system. The manipulator system comprises several manipulators, which render it possible to correct wave front errors by changing the state of individual optical elements of the projection lens. Examples for such a state change comprise: a change in position in one or more of the six rigid body degrees of freedom of the relevant optical element, an impingement of the optical element with heat and/or coldness, a deformation of the optical element or a material ablation at the optical element by means of a post-processing device. Within the scope of this application, such a post-processing device is also understood as a manipulator of the projection lens in the general sense thereof.

Changes of the manipulator to be carried out in order to correct an aberration characteristic of a projection lens are calculated by means of a travel-generating optimization algorithm, which is also referred to as "manipulator change model". By way of example, such optimization algorithms are described in DE 10 2015 222 097 A1. The state changes to be carried out by the manipulators of the manipulator system are provided by the optimization algorithm in form of a so-called control command.

Thus, optimization algorithms known from the prior art may be configured to solve an optimization problem, which is configured to minimize a merit function, also referred to as figure-of-merit function. A typical merit function comprises a sensitivity matrix, the above-mentioned control command with travel paths or travels for the individual manipulators and a state vector of the projection lens which describes a measured aberration characteristic of the projection lens, such as measured wave front deviations of the projection lens.

Here, a "travel" is understood to mean a change in the state variable of an optical element, carried out by means of manipulator actuation, along the travel for the purposes of changing the optical effect thereof. Such a travel defined by changes in the state variable of the optical element is specified by way of target change variables of the associated manipulator.

Control commands generated in the conventional way, however, are often quite imprecise and do not fully comply with the growing requirements on the correction accuracy of the imaging behavior of projection exposure apparatuses.

Underlying object

It is an object of the invention to provide a method of the type set forth at the outset, by means of which the aforementioned problems are solved and, in particular, an improved correction accuracy of the imaging behavior of the projection exposure apparatus can be obtained.

Solution according to the invention

By way of example, according to the invention, the aforementioned object can be achieved by a method of operating a microlithographic projection exposure apparatus. The projection exposure apparatus comprises a mask holder for holding a mask, a substrate holder for holding a substrate, a projection lens having several optical elements for imaging mask structures of the mask onto the substrate and a manipulator system, wherein the optical elements, the mask holder and the substrate holder each are an optical path element in an exposure optical path of the projection exposure apparatus and the manipulator system is configured for adjusting several travels, defined by travel variables, at the optical path elements of the projection lens. The method comprises the following steps: providing a wave front deviation of the projection lens, and determining a control command comprising travels for the manipulator system for correcting the wave front deviation using a model. The model describes the wave front deviation as a function of the travel variables and for this comprises a group of offset coefficients, which are independent of the travel variables, a group of linear coefficients, which are each attributed to one of the travel variables to the power of one, and a group of quadratic coefficients, which are each attributed to a product of two of the travel variables or to a square of one of the travel variables. Further, according to the inventive method the offset coefficients are calibrated more frequently than the linear coefficients.

In other words the time span between two calibrations of the offset coefficients is shorter than the time span between two calibrations of the linear coefficients, wherein the latter time span can also be indefinite in case the linear coefficients are only calibrated once. The travels may contain movements, tilts and/or deviation profiles for some or each one of the optical elements and movements and/or tilts of the mask holder and the substrate holder.

The measure according to the invention to use a model describing the wave front deviation as a function of the travel variables and for this comprising a group of offset coefficients, a group of linear coefficients and a group of quadratic coefficients allows for a more precise determination of the control command resulting in an improved correction accuracy of the imaging behavior of the projection exposure apparatus. However, in order to be precise, the model has to be calibrated frequently, which is very time consuming and has the potential of slowing down the exposure operation of the microlithographic projection exposure apparatus. In order to minimize this potential slowdown, according to the invention different groups of coefficients are calibrated with different repetition rates. This way the calibration can be customized such that the most critical coefficients and/or coefficients typically changing in short time intervals are calibrated more frequently than less critical coefficients and/or coefficients typically changing in a longer time interval. This way the correction accuracy of the imaging behavior of the projection exposure apparatus can be improved with the least possible slowdown in the exposure process.

According to an embodiment the offset coefficients are calibrated more frequently than the quadratic coefficients.

According to a further embodiment the linear coefficients are calibrated more frequently than the quadratic coefficients.

According to a further embodiment, when exposing several substrates, the offset coefficients are calibrated respectively before the exposure of the respective substrate.

According to a further embodiment the calibration of the offset coefficients is performed by means of a wave front measurement at a current operating point of the projection exposure apparatus.

According to a further embodiment a correction of the control command, resulting from a recalibration of the offset coefficients, initiates only a lateral shift of the mask and/or the substrate. The lateral shift of the mask is also referred to in this text as "reticle align step". According to another embodiment a correction of the control command, resulting from a recalibration of the offset coefficients, initiates a lateral shift of the mask and/or the substrate and further another correction, such as an axial shift, of the mask and/or the substrate.

According to a further embodiment the linear coefficients are calibrated at least once after installation of the projection exposure apparatus at the operating location.

According to a further embodiment the calibration of the offset coefficients and the linear coefficients is respectively performed by measurement.

According to a further embodiment the quadratic coefficients are calibrated on the basis of design data of the projection lens.

According to a further embodiment, in exposing a substrate, several fields on the substrate are exposed successively by consecutively scanning the fields, wherein several updated wave front settings, taking into account a topography of the substrate surface, are provided during the scanning of the respective field, and wherein the control command is respectively redetermined for each updated wave front deviation. The topography of the substrate surface is preferably measured before the exposure of the substrate using a suitable metrology device.

According to a further embodiment the wave front settings are updated in a time span of less than 10 ms.

According to a further embodiment the control command comprises first travels for the optical elements determined to cause variations in a focus profile of the projection lens and second travels for the mask holder and/or the substrate holder determined to correct image position deviations caused by adjusting the optical elements based on the first travels. The optical elements may be mirror elements, advantageously mirror elements for reflecting EUV-radiation.

According to a further embodiment neutral combinations of degrees of freedom of the manipulator system, adjustable via the travel variables, are determined, which combinations result in a wave front correction to an extent negligible in comparison to other combinations, and the travels are reduced by utilizing the neutral combinations when determining the control command. That means, when determining the control command the neutral combinations are used such that as small as possible travels are required for correcting the wave front deviation. In different words, the travels determined without using the neutral combinations are reduced by the algorithm by using the neutral combinations. A wave front correction to an extent negligible in comparison to other combinations is understood as a correction smaller than 1%, in particular smaller than 0.1% or 0.2% of a correction caused by a combination of degrees of freedom, in which the wave front correction is performed to maximum extent. The neutral combinations may also be referred to as pseudo manipulators.

According to a further embodiment the deviations of actual travels, adjusted on the basis of the control command, from the travels, specified by the control command, are measured using several measurement devices, wherein the measurement devices are calibrated before determining the control command.

According to a further embodiment the microlithographic projection exposure apparatus uses EUV radiation as exposure radiation. In this case all optical elements are mirror elements.

The features specified in respect of the embodiments, exemplary embodiments and embodiment variants etc. are explained in the description of the figures and in the claims. The individual features can be implemented, either separately or in combination, as embodiments of the invention. Furthermore, they can describe advantageous embodiments which are independently protectable and protection for which is claimed if appropriate only during or after pendency of the application.

Brief description of the drawings

The above and further advantageous features of the invention are illustrated in the following detailed description of exemplary embodiments according to the invention with reference to the accompanying schematic drawings. In detail:

Figure 1 shows a visualization of an embodiment of a microlithographic projection exposure apparatus comprising a control module for controlling manipulators of a projection lens comprising a wavefront encoder and a travel establishing device,

figure 2 shows an embodiment of the travel establishing device configured to determine a control command from updated wavefront settings received from the wavefront encoder, wherein the control command is determined using a model comprising offset coefficients, linear coefficients and quadratic coefficients,

figure 3 illustrates the frequency of calibration of the offset coefficients, the linear coefficients and the quadratic coefficients, and

figure 4 shows a distance measurement device used for calibrating the manipulators of the projection lens.

Detailed description of exemplary embodiments according to the invention

In the exemplary embodiments or embodiments or embodiment variants described below, elements which are functionally or structurally similar to one another are provided with the same or similar reference signs as far as possible. Therefore, for understanding the features of the individual elements of a specific exemplary embodiment, reference should be made to the description of other exemplary embodiments or the general description of the invention.

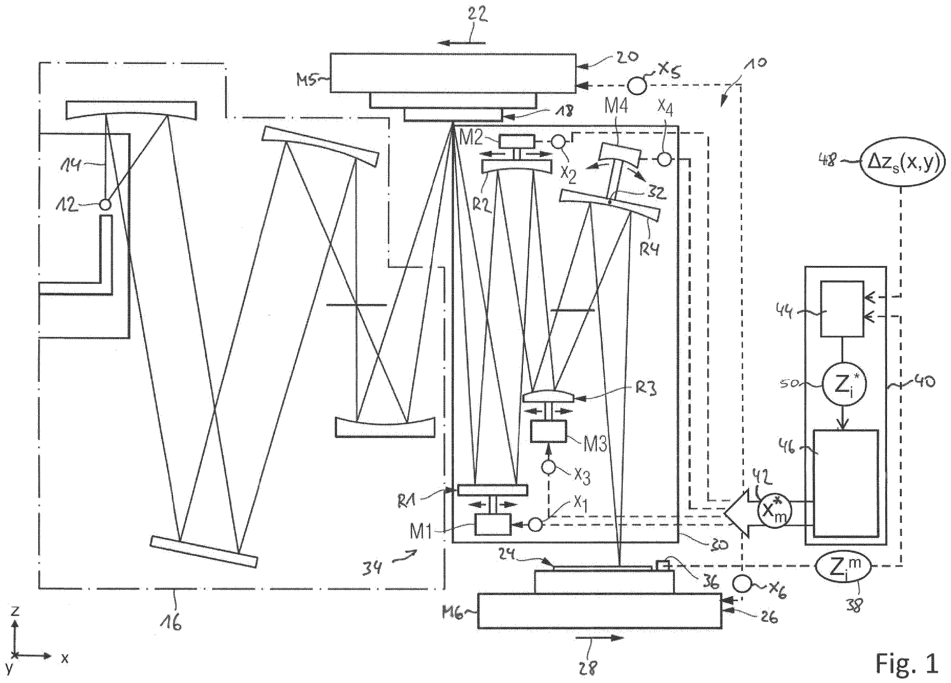

In order to facilitate the description, a Cartesian xyz-coordinate system is indicated in the drawing, from which system the respective positional relationship of the components illustrated in the figures is evident. In Figure 1, the y-direction runs perpendicular and into the drawing plane, the x-direction toward the right, and the z-direction upward.

Figure 1 shows an embodiment according to the invention of a microlithographic projection exposure apparatus 10. The present embodiment is designed for operation in the EUV wavelength range, i.e. at a wavelength below 100 nm, e.g. at around 13.5 nm or at around 6.8 nm. All optical elements are embodied as mirrors as a result of this operating wavelength. However, the invention is not restricted to projection exposure apparatuses in the EUV wavelength range. Further embodiments according to the invention are designed, for example, for operating wavelengths in the UV range, such as e.g. 365 nm, 248 nm or 193 mm. In this case, at least some of the optical elements are configured as conventional transmission lens elements.

The projection exposure apparatus 10 in accordance with figure 1 comprises an exposure radiation source 12 for generating exposure radiation 14. In the present case, the exposure radiation source 12 is embodied as an EUV source and it can comprise, for example, a plasma radiation source. The exposure radiation 14 initially passes through an illumination optical unit 16, which typically comprises several optical elements, and it is guided onto a mask 18 thereby. The illumination optical unit 16 is configured to generate different angle distributions of the exposure radiation 14 incident on the mask 18. Depending on an illumination setting desired by the user, the illumination optical unit 16 configures the angle distribution of the exposure radiation 14 incident on the mask 18. Examples for selectable illumination settings comprise a so-called dipole illumination, annular illumination and quadrupole illumination.

The mask 18 has mask structures to be imaged on a substrate 24 in the form of a wafer and it is displaceably mounted on a mask holder 20 in form of a mask displacement stage. As depicted in figure 1, the mask 18 can be embodied as a reflection mask or, alternatively, it can also be configured as a transmission mask, in particular for UV lithography. In the embodiment in accordance with figure 1, the exposure radiation 14 is reflected at the mask 18 and it thereupon passes through a projection lens 30.

The projection lens 30 serves to image the mask structures of the mask 18 on the substrate 24. The exposure radiation 14 is guided within the projection lens 30 by means of a multiplicity of optical elements, presently in the form of mirrors R1 to R4. The path of the exposure radiation 14 initiating at the exposure radiation source 12, traversing the illumination optical unit 15, and the projection lens 30 and ending at the substrate 24 is referred to as exposure optical path of the projection exposure apparatus 10. The substrate 24 is displaceably mounted on a substrate holder 26 in form of a substrate displacement stage. The projection exposure apparatus 10 can be designed as a so-called scanner or a so-called stepper.

In case the projection exposure apparatus is a scanner, which is also referred to as a step- and scan projection exposure apparatus, the mask holder 20 and the substrate holder 26 are moved in opposite directions during each instance of imaging the mask 18 on the substrate 24, i.e. each instance of exposing a field on the substrate 24. As shown in figure 1, for example, the mask holder 20 moves in a scanning direction 22 pointing to the left and the substrate displacement stage moves in a scanning direction 28 pointing to the right.

All mirrors R1 to R4 of the projection lens 30 are mounted in a movable manner. To this end, a respective manipulator MS, namely respectively one of the manipulators M1 to M4, is assigned to each one of the mirrors R1 to R4. The manipulators M1, M2 and M3 each enable a displacement of the assigned mirrors R1, R2 and R3 in the x- and y-direction and therefore substantially parallel to the plane in which the respective reflecting surface of the mirrors lies.

The manipulator M4 is configured to tilt the mirror R4 by rotation about a tilt axis 32 arranged parallel to the y-axis. As a result, the angle of the reflecting surface of R4 is changed in relation to the incident radiation. Further degrees of freedom for the manipulators are conceivable. Thus, for example, provision can be made for a displacement of the relevant optical element transversely to the optical surface thereof or for a rotation about a reference axis perpendicular to the reflecting surface.

In general terms, each one of the manipulators M1 to M4 illustrated here is provided to bring about a displacement of the assigned optical element R1 to R4 while performing a rigid body movement along a predetermined travel. By way of example, such a travel can combine translations in different directions, tilts and/or rotations in any manner. Alternatively or additionally, it is also possible to provide manipulators which are configured to undertake a differently mannered change of a state variable of the assigned mirror by an appropriate actuation of the manipulator. In this respect, an actuation can be carried out by e.g. applying a specific temperature distribution or specific force distribution to the mirror. In this case, the travel can be a result of a change in the temperature distribution of the optical element or the application of local tension to an optical element embodied as a deformable lens or as a deformable mirror.

The mirrors R1 to R4, the mask holder 20 and the substrate holder 26 all serve to form the optical path of the exposure radiation 14 in the area or the projection lens 30 and are therefore also referred to as optical path elements. As mentioned above, the mask holder 20 is configured to move the mask 18 in the scanning direction 22. Further it may be configured to move the mask 18 in other directions and/or tilt the mask 18. According to an embodiment, the mask holder 20 may be configured to perform all six rigid body movements. The mask holder 20 is therefore also referred to as manipulator M5. Analogously the substrate holder 26 may be configured to move the substrate 24, in addition to the scanning direction 28, in other directions and/or tilt the substrate. According to an embodiment, the substrate holder 26 may be configured to perform all six rigid body movements. The substrate holder 26 is therefore also referred to as manipulator M6. The set of all manipulators, in the present case the manipulators M1 to M6, is referred to as manipulator system 34.

The projection exposure apparatus 10 further comprises a control module 40, which determines a control command 42 comprising $n_m$ travels $x_m^*$ for the manipulator system 34. In the shown case, $n_m = 6$, the travels $x_m^*$ comprised by the travel command 42 contain the travels $x_1$, $x_2$, $x_3$, $x_4$, $x_5$ and $x_6$, which specify changes to be carried out by the manipulators M1 to M6 and which therefore serve to control the manipulators M1 to M6 of the projection lens 30. The established travels $x_1$ to $x_6$ are transferred to the individual manipulators M1 to M6 by way of travel signals and they provide said manipulators with respective correction travels to be carried out. These define corresponding displacements of the assigned optical path elements R1 to R4, 20 and 26 for correcting current wavefront errors of the projection lens 30 as explained subsequently in more detail.

For example, the control command 42 may contain first travels $x_1$, $x_2$, $x_3$ and $x_4$ for the mirrors manipulators M1 to M4 of the mirrors R1 to R4 determined to cause variations in a focus profile of the projection lens 30 and second travels $x_5$ and $x_6$ for the manipulators M5 and M6 of the mask holder 20 and the substrate holder 26 to correct image position deviations in the substrate plane caused by adjusting the mirrors R1 to R4 based on the first travels $x_1$, $x_2$, $x_3$ and $x_4$.

A wavefront measurement device 36 is integrated into the substrate holder 26 and is configured to measure a wavefront deviation 38 in form of wavefront aberrations $Z_i^m$ of the projection lens 30. By way of example, such a measurement can take place regularly after each exposure of a substrate 24 or in each case after exposing a complete set of substrates 24. Alternatively, it is also possible to undertake a simulation or a combination of a simulation and a reduced measurement.

The wavefront deviation 38 measured by the wavefront measuring device 36 are provided in the form of Zernike coefficients $Z_i^m$. In the present application, the Zernike functions $Z_m^n$, as known from e.g. Chapter 13.2.3 in the textbook "Optical Shop Testing", 2nd Edition (1992) by Daniel Malacara, pub. John Wiley & Sons, Inc., are denoted by $Z_j$ in accordance with the so-called fringe sorting, as described in e.g. paragraphs [0125]-[0129] in US 2013/0188246A1, with $b_j$ then being the Zernike coefficients assigned to the respective Zernike polynomials (also referred to as "Zernike functions"). The fringe sorting is visualized, for example, in Table 20-2 on page 215 of the "Handbook of Optical Systems", Vol. 2 by H. Gross, 2005 Wiley-VCH Verlag GmbH & Co. KgaA, Weinheim. The wavefront deviation $W(\rho, \Phi)$ at a point in the object plane of the projection lens is then developed as follows in a manner dependent on the polar coordinates $(\rho, \Phi)$ of the pupil

plane:

$$W(\rho, \Phi) = \sum_j b_j \cdot Z_j(\rho, \Phi) \qquad (1)$$

While the Zernike functions are denoted by $Z_j$, i.e. with the subscript index j, the Zernike coefficients are denoted by $b_j$ or $Z_i$, such as $Z_i^m$ for the measured coefficients, within the scope of this application. It should be noted here that the Zernike coefficients $b_j$ are often also denoted by Zi, i.e. with a normally written index, in the specialist world, such as e.g. Z5 and Z6 representing astigmatism.

The control module 40 comprises a wavefront encoder 44 and a travel establishing device 46. The measured wavefront aberrations $Z_i^m$ are periodically (e.g. before the exposure of each substrate 24) fed into the wavefront encoder 44. Before exposing a substrate 24, the topography of the substrate surface is measured using a suitable metrology device not shown in the drawings. The measured surface topography data 48 in form of deviations $\Delta z_s(x,y)$ of the substrate surface from a plane reference surface as a function of the substrate coordinates x and y are also fed into the wavefront encoder 44. When exposing the substrate 24 several fields on the substrate 24 are exposed successively by consecutively scanning the fields. During the scanning of the fields the wavefront encoder 44 continuously generates updated wavefront settings $Z_i^*$ (reference number 50) at an update frequency of more than 100 Hz. That means, the time span between updates of the wavefront setting $Z_i^*$ is less than 10 ms. The updated wavefront settings $Z_i^*$ are generated by modifying the measured wavefront aberrations $Z_i^m$ taking into account the measured topography of the respective substrate at the position currently scanned based on the topography data $\Delta z_s(x,y)$. The updated wavefront settings $Z_i^*$ are fed to the travel establishing device 46 which determines the control command 42 therefrom.

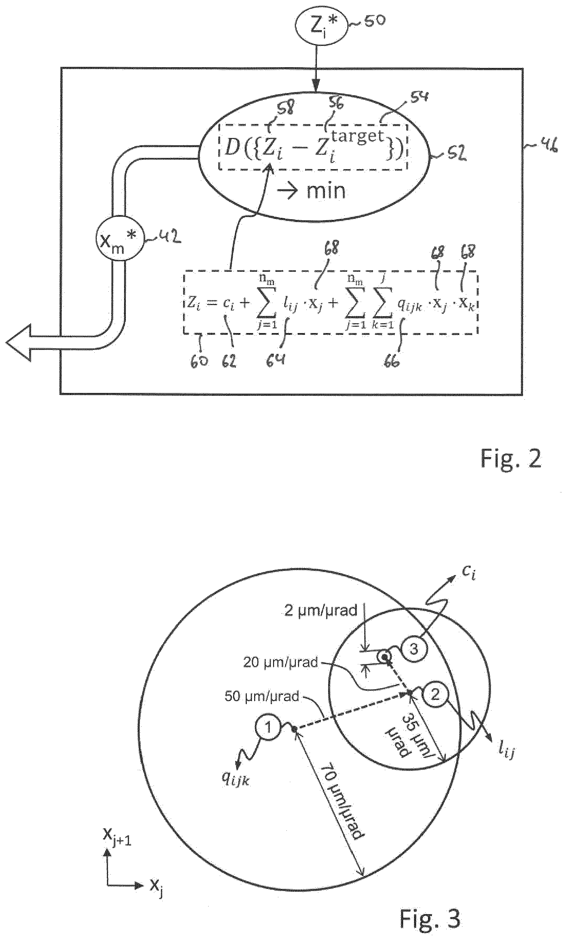

In figure 2 an embodiment of the travel establishing device 46 is illustrated. The travel establishing device 46 is configured to execute an optimization algorithm 52 and thereby minimize a merit function 54 in order to determine the control command $x_m^*$ (reference number 42). According to an embodiment the merit function 54 is as follows:

$$D(\{Z_i - Z_i^{\text{target}}\}) \qquad (2)$$

Herein D is a metric, such as e.g. the square of the Euclidean norm $\|\,\|_2$. $Z_i^{\text{target}}$ denotes the target wavefront 56, which is here set at the negative value of the updated wavefront setting $Z_i^*$ received from the wavefront encoder 44. $Z_i$ is a sensitivity function $Z_i(\{x_j\})$ (reference number 58), which represents a relationship between the travel variables $x_m$ defining the travels $x_m^*$ of the control command 42 and the respective wave front change $Z_i$, i.e. the corresponding wave front deviation of the projection lens 30. The merit function may additionally comprise further terms, such as penalty terms (e.g. in Tikhonov-form) for manipulator travels in order to ensure as small as possible travels.

The resulting optimization problem is as follows:

$$\left\{x_j^{\text{opt}}\right\} = \min_{x_j} D(\{Z_i - Z_i^{\text{target}}\}) \qquad (3)$$

The values $\left\{x_j^{\text{opt}}\right\}$ determined hereby are output as the travels $x_m^*$ of the control command 42. Further, the metric may be expanded such that not only the desired corrective wave front effect is achieved as precisely as possible, but also the travels of the stepping/scanning process are chosen favorably. This may be expedient, as large travels in some degrees of freedom may lead to oscillations of optical components (e.g. the mirrors), which do not subside timely enough to have no impact on the exposure of the following fieldi on the substrate 24. Therefore, short travels in some degrees of freedom of the manipulator system 34 may be preferable in order to avoid delays in the exposure process.

The sensitivity function 58 is based on the following nonlinear model 60

$$Z_i = c_i + \sum_{j=1}^{n_m} l_{ij} \cdot x_j + \sum_{j=1}^{n_m} \sum_{k=1}^{j} q_{ijk} \cdot x_j \cdot x_k \qquad\qquad (4)$$

Herein $n_m$ is the number of travels $x_m{}^*$, $x_j$ and $x_k$ are travel variables (reference number 68) defining the travels $x_m{}^*$, $c_i$ denotes a group of offset coefficients 62, also referred to as constant coefficients, $l_{ij}$ denotes a group of linear coefficients 64 and $q_{ijk}$ a group of quadratic coefficients 66.

The offset coefficients 62 are independent of the travel variables 68. The linear coefficients $l_{ij}$ are each attributed

to one of the travel variables $x_j$, therefore $\displaystyle\sum_{j=1}^{n_m} l_{ij} \cdot x_j$ constitutes a plurality of linear terms. The quadratic coefficients

$q_{ijk}$ are each attributed to a product of two travel variables $(x_j \cdot x_j)$, therefore $\displaystyle\sum_{j=1}^{n_m} \sum_{k=1}^{j} q_{ijk} \cdot x_j \cdot x_k$ constitutes a plurality of quadratic and therefore nonlinear terms.

As illustrated in figure 3, the group of offset coefficients $c_i$, the group of linear coefficients $l_{ij}$ and the group of quadratic coefficients $q_{ijk}$ are calibrated with at least two different repetition rates, i.e. the time span between recalibration of the different groups of coefficients is different for at least two of the groups.

According to an embodiment the quadratic coefficients $q_{ijk}$ are calibrated only once, that is after the manufacture of the projection lens 30 and before the projection exposure apparatus 10 is set up in a semiconductor fab. In this case the time span between recalibration is indefinite and therefore the repetition rate is zero. The calibration of the quadratic coefficients $q_{ijk}$ is performed on the basis of the design data of the projection lens 30, i.e. by simulation of the quadratic coefficients $q_{ijk}$ based on the design data. In the example shown in figure 3, illustrating travel settings for two exemplary degrees of freedom $x_j$ and $x_{j+1}$, the calibration of the quadratic coefficients $q_{ijk}$, indicated with the numeral (1), results in a correction of about 50 $\mu$m or $\mu$rad in the plane of the travel settings $x_j$ and $x_{j+1}$. The correction should be typically within a radius of 70 $\mu$m/$\mu$rad around the setpoint (1) before the calibration of the quadratic coefficients $q_{ijk}$.

In the example according to figure 3, the calibration of the linear coefficients $l_{ij}$, indicated with the numeral (2), is performed at least once after the setup of the projection exposure apparatus 10 at the operating location in the semiconductor fab. The calibration may be performed in regular time intervals after the setup of the projection exposure apparatus e.g. once a month. In other words, in the latter case the linear coefficients $l_{ij}$ are calibrated more frequently than the quadratic coefficients $q_{ijk}$. The calibration of the linear coeffients $l_{ij}$ is performed by wavefront measurement, e.g. using the wavefront measuring device 36. According to an embodiment, the calibration procedure includes respective measurements of the wavefront deviations $Z_i{}^m$ at different settings of the travels $x_m$. In the example shown in figure 3, illustrating travel settings for two exemplary degrees of freedom $x_j$ and $x_{j+1}$, the calibration of the linear coefficients $l_{ij}$ indicated with the numeral (2), results in a correction of about 20 $\mu$m or $\mu$rad in the plane of the travel settings $x_j$ and $x_{j+1}$. The correction should be typically within a radius of 35 $\mu$m/$\mu$rad around the setpoint (2) before the calibration of the linear coefficients $l_{ij}$.

According to an embodiment, during the exposure operation of the projection exposure apparatus, the calibration of the offset coefficients $c_i$, indicated with the numeral (3), is performed respectively before the exposure of each substrate 24. Alternatively the calibration may be performed always after a number of wafers, respectively, e.g. after a lot of wafers. In any case the calibration of the offset coefficients $c_i$ is performed more frequently than the calibration of the linear coefficients $l_{ij}$ and more frequently than the calibration of the quadratic coefficients $q_{ijk}$. The calibration of the offset coefficients $c_i$ is performed by wavefront measurement, e.g. using the wavefront measuring device 36 at the respective current operating point of the projection exposure apparatus 10. In the example shown in figure 3, illustrating travel settings for two exemplary degrees of freedom $x_j$ and $x_{j+1}$, the calibration of the offset coefficients $c_i$ indicated with the numeral (3), results in a correction of about 1 $\mu$m or $\mu$rad in the plane of the travel settings $x_j$ and $x_{j+1}$. The correction should be typically within a radius of 2 $\mu$m/$\mu$rad around the setpoint (3) before the calibration of the offset coefficients $c_i$, also referred to above as current operating point of the projection exposure apparatus 10.

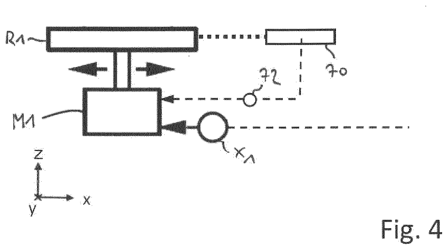

The correction of the control command 42, resulting from a recalibration of the offset coefficients $c_i$, may correspond to only a lateral shift of the mask 18 and/or the substrate 24. This shift may then be performed by a so-called reticle align step, in which a corresponding lateral shift of the mask and/or the substrate is performed. The manipulator system 34 comprises a system of measurement devices configured to measure deviations of actual travels, as adjusted on the basis of the control command 42, from desired travels $x_m$, as specified by the control command 42. In other words, the measurement devices determine deviations between the desired travels $x_m$ and the actual travels performed by the manipulators. The measurement devices may be interferometers, therefore the system of measurement devices may be referred to as interferometer system. Figure 4 illustrates the operating principle of such an interferometer system by the example of an interferometric distance measurement device 70 which is arranged to measure the x-position of mirror R1 as adjusted by the manipulator M1 on the basis of the travel $x_1$ and feed this measurement information 72 to a control unit of the manipulator M1. The control unit uses the measurement information 72 to adjust the manipulator response to the travel $x_1$.

Often there are deviations of the measurement devices from an initial state, e.g. due to imprecisely positioned measurement mirrors for the interferometers. These deviations result in imprecise position data, which may induce aberration inaccuracies after multiplication with the sensitivity. In order to reduce or eliminate this error contribution a calibration as explained in the following is performed.

According to an embodiment the interferometric distance measurement device 70 comprises a measurement head with a coherent light source, which is fixed to a sensor frame of the projection lens 30, and a mirror as counter part on a force frame. However, the positions and orientations of the sensor heads and the target mirror are only known to a certain degree of precision. In order to obtain the optical image of a real projection lens as error free as possible, exact knowledge of the positions of the optically active elements is required. This is achieved by the linear calibration of the optical measurement system using the following provision:

$$\vec{y} = \overline{K} \cdot \vec{x} + \vec{y}_0 .$$

When shifting a certain element of the nominal system $\vec{x}$ a certain simulated measurement result of the interferometer system $\vec{y}$ is obtained. Due to the large deviation in position and orientation from the respective target state, the absolute value of the measurement result of an interferometer $\vec{y}_0$ is of special numeric size for the calibration and therefore of special importance.

In other words, often there are deviations of the measurement devices from an initial state, e.g. due to imprecisely positioned measurement mirrors for the interferometers. These deviations result in imprecise position data, which may induce aberration inaccuracies after multiplication with the sensitivity. In order to reduce or eliminate this error contribution a calibration as explained in the following is performed.

The system of measurement devices, including device 70, is calibrated before the control command 42 is determined, i.e. before the projection exposure apparatus 10 is put into operation. An embodiment of this calibration is explained referring to measurement device 72. Here the mirror R1 is moved in x-direction by a uniform distance and the change of the measurement information 72 is documented. This is done for all six degrees of freedom in a calibration matrix K. This procedure is repeated for all single axes to generate a linear calibration matrix for mirror R1. This procedure is performed for all optical path elements.

In order to verify the quality of the calibration, all interferometric measurements with respect to nominal travels $\vec{x}_{nominal}$ are simulated analogously to the wave front calibration. By using these interferometric measurements the corresponding real travels $\vec{x}_{real}$ may be determined by inverting the equation with respect to $\vec{x}$: $\vec{x} = \overline{K}^{-1} \cdot (\vec{y} - \vec{y}_0)$. A wavefront calculation for $\vec{x}_{nominal}$ and $\vec{x}_{real}$ allows the calibration result to be evaluated. As in the wave front calibration the result of the interferometer calibration can be improved by a factor of ten by setting the aberration error at the operation point (reticle align) to zero.

According to an embodiment, the travel establishing device 46 is configured to determine the travel command 42 in such a way that the path lengths of the travels $x_m{}^*$ are kept short or are minimized by utilizing so-called neutral combinations of degrees of freedom of the manipulator system 34. Such neutral combinations, adjustable via the travel variables, are combinations which result in a wave front correction to an extent negligible in comparison to other combinations. The travel establishing device 46 is configured to determine such neutral combinations and use them to reduce the path lengths of the travels $x_m{}^*$.

Expressed differently, when determining the control command 42, the neutral combinations are used such that as small as possible travels $x_m{}^*$ are required for correcting the wavefront settings $Z_i{}^*$, i.e. the travels determined without using the neutral combinations are reduced by the algorithm by using the neutral combinations. In the following the motivation behind the use of neutral combinations and advantageous applications are explained further.

A source inaccuracy in measuring image errors is a dynamic contribution: the larger the measurement signal, the larger is its error in absolute terms (e.g. with a fixed relative portion). For achieving high accuracies in such a calibration step it is therefore expedient to achieve small aberration signals with large travel paths. This may be contradictory at first sight, however it can be achieved when using neutral linear combinations of sensitivities.

As already explained, it is an objective to improve the imaging quality of the projection lens 30 by changing the respective degrees of freedom, both in position and in orientation, of optical path elements. This dependency may be described in first approximation by linear sensitivities, wherein the wave front effect is the result of a linear combination of all sensitivities weighted with the respective travels. As the wave front effect itself is represented by a Zernike polynomial development, the linear sensitivities are a matrix with the coefficients of the Zernike polynomials and the rigid body degrees of freedom as the two dimensions.

The matrix of the linear sensitivities may be diagonalized by singular value decomposition. Thereby, the singular values may be determined, the singular vectors attributed thereto representing linear combinations of degrees of freedom and being referred to as pseudo manipulators. This basis of pseudo manipulators is of great value for the operation of the projection lens 30. For example, only a small number of the pseudo manipulators with especially large optical effect may be used resulting in a reduction of dimension. In this context, however, also those singular values with the attributed vectors having the smallest optical effect appear. With their use configurations of the projection lens 30 having almost unchanged optical properties may be generated.

A further advantage of these almost aberration neutral degrees of freedom is that these degrees of freedom are suitable to reduce the travels required in reality. In case it is desired to induce a certain imaging deviation $\Delta Z$, this can be achieved in different ways, i.e. different vectors $\vec{x}$ may have the same effect. In case one of the degrees of freedom $\vec{x}^i$ (i - number of the degree of freedom, e.g. y-movement of mirror R2) is too large, a neutral vector $\vec{n}$ may be added which leaves $\Delta Z$ unchanged, but reduces $\vec{x}^i$ in a targeted manner.

In the following, the concept of the invention and further aspects thereof are explained. The terminology used for this may be different to the above description.

Different configurations of the projection lens 30 in the projection exposure apparatus 10 comprising all mirrors, the reticle and the wafer result in various sensitivities. Hereby, the use of pre-calculated sensitivities is inevitable due to the short duration of the exposure process. The adaptation of these sensitivities to different configurations may be performed in the context of a calibration. Hereby, it is to be considered that the calibration and the corresponding adjustment on the basis of the calibration results is directed towards the interaction of all single elements of the projection lens 30 and the wave front calibration refers only to the optical components.

First of all, an ideal projection lens has to be distinguished from a real projection lens. The design point of an ideal projection lens is at $\vec{x} = 0$, all optical surfaces have the perfect shape. In a real projection lens the configuration of the setpoint often differs from the configuration of the ideal system very clearly, as the shapes of the mirrors differ from their design specifications, which is partially compensated by changes of the mirror positions.

In order to describe such real systems shape deviations for each optical surface and a correction recipe for the rigid body degrees of freedom of the optically active elements, which corresponds to a travel path from the design point of the ideal system to the setpoint of the real system, are determined.

In the course of a calibration strategy for the wave front of a configuration of the projection lens the model $Z(\vec{x}) = c + \vec{a} \cdot \vec{x} + \vec{x}^T \cdot \vec{M} \cdot \vec{x}$ is used for an aberration $Z(\vec{x})$, wherein a certain configuration $\vec{x}$ of the projection lens is described by a linear combination of manipulator degrees of freedom of all movable rigid bodies involved in the optical imaging process. In the case of an ideal projection lens for which calibration is performed around the design point, this general model of second order does not have an absolute portion c, as the assumption is made that the projection lens images without errors at the design point $\vec{x}$.

Corresponding to the above equation the image errors have a hierarchy with increasing order. Contributions of higher derivatives are expectedly significantly smaller than those of lower derivatives. The further the manipulators are moved blindly, the higher derivatives of the aberrations with respect to the manipulator position (in the present case mirror positions) have to be taken in consideration. Typically, it is assumed that the operating point $\vec{x}$ of a projection lens is located closer to the setpoint than the latter is located to the design point.

This hierarchy of the image errors corresponds to a sensitivity of the correspond-ing sensitivity to the distance $\vec{x}$ from the calibration point. As the zeroth derivative the aberration itself represents as an absolute term the dominant contribution. Following the ascending sequence of the order, the linear portion and correspond-ingly the linear sensitivities $\vec{a}$, which are to be understood as the first derivative of the image error with respect to all manipulator directions

$$\vec{a} = \frac{dZ(\vec{x})}{d\vec{x}}$$

, are the next important contributions based on their effect. The quadratic portion considers via the sensitivity matrix $\vec{M}$ a bilinear coupling of two degrees of freedom, respectively, and has a significantly smaller effect than the linear contribution. This aspect can be used by choosing different calibration points for the sensitivities of different order.

As explained above with regard to Fig. 3, a procedure of a phase calibration is performed. For this, the quadratic sensitivities only have to be determined once at the design point of the ideal system and can be used for all real systems by extracting them by "scheduling" from a value table. Here it is assumed that the design point in the multi-dimensional space of the degrees of freedom is located the most distant from the operating point.

Due to a larger effect on the optical image errors in comparison to the quadratic sensitivities the calibration point of the linear sensitivities in the multi-dimensional space of the rigid body degrees of freedom should be "closer" to the operating point of the projection lens. For this purpose the setpoint of the real system is used.

A particularly effective measure is based on an additional step, the so-called "reticle align" step. For this the aberration itself is set to zero by means of a wave front measurement at the operating point. In case, as detailed above, a blind pre-correction around this operating point is performed, an aberration is reestablished according to the quadratic wave front model. By the additional "reticle align" calibration step the error level is reduced to approximately one tenth of its original level.

The hierarchical principle ensures that only a small number of calibration steps is needed. After all, the number of aberrations as the zeroth derivative is smaller than the number of the first derivatives (6N for N optical parts in case of rigid body degrees of freedom) with respect to all mirror positions. Therefore, the effort of calibrating the aberrations can be managed the most frequently.

Thereafter, the first derivatives, the sensitivities, follow. They are calibrated with significantly larger effort at the setpoint. In return their range of validity stretches significantly further, therefore the higher effort has to be made less often and therefore remains manageable.

Again significantly more calibrations ($[6N]^2$ for N optical parts in case of rigid body degrees of freedom) would have to be performed for second derivatives. It became evident that normally the design parameters for the second derivatives have sufficient range, therefore calibration steps are not necessary for these. In case second derivatives nevertheless display a relevant variation along the travel paths for a particularly sensitive system or for higher accuracy requirements, it is expedient to determine an order of priority of a ranking of this sensitivity and calibrate only the most critical second derivatives in order to make sure the calibration effort is manageable. Still the calibration of the second derivatives should again be required significantly less often than calibration of the first derivatives.

This calibration procedure primarily refers to image position errors, mathematically described by the Zernike coefficients Z2, Z3 and Z4. Mechanical movements are increasingly less efficient for correcting higher image errors of the optical elements, Zernike coefficients of Z16 and higher are almost impossible to correct using rigid body degrees of freedom.

The present description of exemplary embodiments is to be understood to be exemplary. The disclosure effected thereby firstly enables the person skilled in the art to understand the present invention and the advantages associated therewith, and secondly encompasses alterations and modifications of the described structures and methods that are also obvious in the understanding of the person skilled in the art. Therefore, all such alterations and modifications, in so far as they fall within the scope of the invention in accordance with the definition in the accompanying claims, and equivalents are intended to be covered by the protection of the claims.

List of reference signs

| 10 | projection exposure apparatus |
|----|----|
| 12 | exposure radiation source |
| 14 | exposure radiation |
| 16 | illumination optical unit |
| 18 | mask |
| 20 | mask holder |
| 22 | scanning direction of the mask displacement stage |
| 24 | substrate |
| 26 | substrate holder |
| 28 | scanning direction of the substrate displacement stage |
| 30 | projection lens |
| 32 | tilt axis |
| 34 | manipulator system |
| 36 | wavefront measuring device |
| 38 | wavefront deviation $Z_i^*$ |
| 40 | control module |
| 42 | control command comprising travels $x_m$ |
| 44 | wavefront encoder |
| 46 | travel establishing device |
| 48 | topography data |
| 50 | updated wavefront settings $Z_i^*$ |
| 52 | optimization algorithm |
| 54 | merit function |
| 56 | target wavefront |

| 58 | sensitivity function |
| 60 | nonlinear model |
| 62 | offset coefficients |
| 64 | linear coefficients |
| 66 | quadratic coefficients |
| 68 | travel variable |
| 70 | interferometric measurement device |
| 72 | measurement information |
| R1 to R4 | Mirrors of projection lens |
| M1 to M6 | Manipulators |

## Claims

1. A method of operating a microlithographic projection exposure apparatus (10) comprising a mask holder (20) for holding a mask (18), a substrate holder (26) for holding a substrate (24), a projection lens (30) having several optical elements (R1 - R4) for imaging mask structures of the mask onto the substrate and a manipulator system (34), wherein the optical elements, the mask holder and the substrate holder each are an optical path element in an exposure optical path of the projection exposure apparatus and the manipulator system is configured for adjusting several travels, defined by travel variables (68), at the optical path elements of the projection lens, the method comprising the following steps:

   - providing a wave front deviation (50) of the projection lens, and
   - determining a control command (42) comprising travels for the manipulator system for correcting the wave front deviation using a model (60),

   wherein the model describes the wave front deviation as a function of the travel variables and for this comprises a group of offset coefficients (62), which are independent of the travel variables, a group of linear coefficients (64), which are each attributed to one of the travel variables to the power of one, and a group of quadratic coefficients (66), which are each attributed to a product of two of the travel variables or to a square of one of the travel variables, and
   wherein the offset coefficients (62) are calibrated more frequently than the linear coefficients (64).

2. The method according to claim 1,
   wherein the offset coefficients (62) are calibrated more frequently than the quadratic coefficients (66).

3. The method according to claim 1 or 2.
   wherein the linear coefficients (64) are calibrated more frequently than the quadratic coefficients (66).

4. The method according to any one of the preceding claims,
   wherein, when exposing several substrates, the offset coefficients (62) are calibrated respectively before the exposure of the respective substrate (24).

5. The method according to any one of the preceding claims,
   wherein the calibration of the offset coefficients (62) is performed by means of a wave front measurement at a current operating point of the projection exposure apparatus.

6. The method according to any one of the preceding claims,
   wherein a correction of the control command (42), resulting from a recalibration of the offset coefficients (62), initiates only a lateral shift of the mask (18) and/or the substrate (24).

7. The method according to any one of the preceding claims,
   wherein the linear coefficients (64) are calibrated at least once after installation of the projection exposure apparatus (10) at the operating location.

8. The method according to any one of the preceding claims,
   wherein the calibration of the offset coefficients and the linear coefficients is respectively performed by measurement.

9. The method according to any one of the preceding claims,

wherein the quadratic coefficients (66) are calibrated on the basis of design data of the projection lens (30).

10. The method according to any one of the preceding claims,
wherein, in exposing a substrate (24), several fields on the substrate are exposed successively by consecutively scanning the fields, wherein several updated wave front settings (50), taking into account a topography (48) of the substrate surface, are provided during the scanning of the respective field, and wherein the control command (42) is respectively redetermined for each updated wave front deviation.

11. The method according to claim 10,
wherein the wave front settings (50) are updated in a time span of less than 10 ms.

12. The method according to claim 10 or 11,
wherein the control command comprises first travels ($x_1$, $x_2$, $x_3$, $x_4$) for the optical elements (R1 - R4) determined to cause variations in a focus profile of the projection lens and second travels (xs, $x_6$) for the mask holder (20) and/or the substrate holder (26) determined to correct image position deviations caused by adjusting the optical elements based on the first travels.

13. The method according to any one of the preceding claims,
wherein neutral combinations of degrees of freedom of the manipulator system (34), adjustable via the travel variables, are determined, which combinations result in a wave front correction to an extent negligible in comparison to other combinations, and the travels are reduced by utilizing the neutral combinations when determining the control command (42).

14. The method according to any one of the preceding claims,
wherein deviations of actual travels, adjusted on the basis of the control command (42), from the travels, specified by the control command, are measured using several measurement devices (70), wherein the measurement devices are calibrated before determining the control command.

15. The method according to any one of the preceding claims,
wherein the microlithographic projection exposure apparatus (10) uses EUV radiation (14) as exposure radiation.

Fig. 1

Fig. 2

Fig. 3

Fig. 4

Europäisches
Patentamt

European
Patent Office

Office européen
des brevets

# EUROPEAN SEARCH REPORT

Application Number

EP 23 19 5956

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 10 2020 210567 B3 (ZEISS CARL SMT GMBH [DE]) 11 November 2021 (2021-11-11) * paragraphs [0012], [0013], [0024], [0053] – [0069], [0082]; figures 2, 3 * ----- | 1-15 | INV. G03F7/20 |
| A | US 2020/225587 A1 (BUTSCHER BJOERN [DE] ET AL) 16 July 2020 (2020-07-16) * paragraphs 11-16, 83-92 – page 5 * ----- | 1-15 | |

TECHNICAL FIELDS
SEARCHED (IPC)

G03F

The present search report has been drawn up for all claims

| Place of search | Date of completion of the search | Examiner |
|---|---|---|
| Munich | 1 March 2024 | Eisner, Klaus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 19 5956

This annex lists the patent family members relating to the patent documents cited in the above-mentioned European search report.
The members are as contained in the European Patent Office EDP file on
The European Patent Office is in no way liable for these particulars which are merely given for the purpose of information.

01-03-2024

| Patent document cited in search report | Publication date | Patent family member(s) | | Publication date |
|---|---|---|---|---|
| DE 102020210567 B3 | 11-11-2021 | DE 102020210567 B3 | | 11-11-2021 |
| | | TW 202221422 A | | 01-06-2022 |
| | | WO 2022038163 A1 | | 24-02-2022 |
| US 2020225587 A1 | 16-07-2020 | DE 102019200218 B3 | | 25-06-2020 |
| | | EP 3680718 A2 | | 15-07-2020 |
| | | JP 2020112786 A | | 27-07-2020 |
| | | US 2020225587 A1 | | 16-07-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102015222097 A1

- US 20130188246 A1

**Non-patent literature cited in the description**

- **DANIEL MALACARA**. Optical Shop Testing. John Wiley & Sons, Inc., 1992

- **H. GROSS**. Handbook of Optical Systems. Wiley-VCH Verlag GmbH & Co., 2005, vol. 2, 215